# EUROPEAN PATENT APPLICATION

(11) **EP 1 115 211 A1**
(43) Date of publication of application: **11.07.2001**
(21) Application number: 00946276.3
(22) Date of filing: 12.07.2000
(51) Int. Cl.: H04B 1/04, H04B 7/26

(54) **METHOD AND APPARATUS FOR POWER AMPLIFICATION**

(30) Priority: 16.07.1999 JP 20300099
(71) Applicant: MATSUSHITA ELECTRIC INDUSTRIAL CO., LTD., Kadoma-shi, Osaka 571-8501 (JP)
(72) Inventor: KINOMURA, Masahiro, Nagatsuru-cho, Hamamatsu-shi, Shizuoka 4 (JP)
(74) Representative: Grünecker, Kinkeldey, Stockmair & Schwanhäusser Anwaltssozietät
(86) International application number: JP0004656
(87) International publication number: WO0106665

(57) **Abstract**

Power amplifier 101 amplifies a high frequency signal, coupler 102 monitors amplification signal power Pₘₒₙᵢ of power amplifier 101, detector 103 half-wave rectifies input power of a certain level or above exceeding the forward voltage of a diode to a linear current, an RC filter integrates the rectified current to generate detection voltage V_{det}, gain /offset amplifier 104 performs at least one of amplification of detection voltage V_{det} and application of an offset voltage, converts detection voltage V_{det} to a desired voltage and uses this voltage as the gate voltage of power amplifier 101. This allows the power amplification apparatus to perform power consumption reduction control in the low power area and at the same time reduce the hardware scale.

## Description

### Technical Field

The present invention relates to an apparatus and method for power amplification used in a communication apparatus of a mobile communication system.

### Background Art

In a power amplifier, when a gate voltage is constant and output power is reduced, the current normally does not fall below a certain value, which results in low efficiency and consumes power more than necessary.

Because of this, conventional power amplification apparatuses lower the gate voltage as the output power decreases and extend the dynamic range of current reduction to a low power area to reduce power consumption in the low power area.

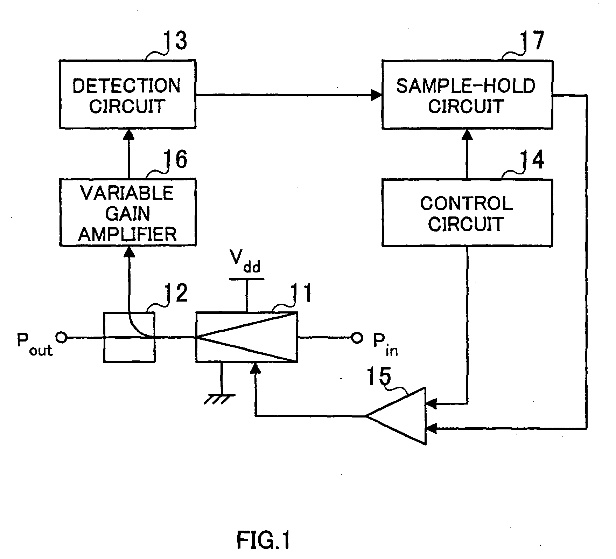

As a conventional power amplification apparatus, the one disclosed in the Unexamined Japanese Patent Publication No.HEI 7-307699 is known. The conventional power amplification apparatus will be explained below using FIG.1. FIG.1 is a main block diagram showing an outlined configuration of the conventional power amplification apparatus.

In FIG.1, power amplifier 11 amplifies gate power. This amplification factor is variable and determined by a control voltage. Coupler (directional coupler) 12 monitors the level of the signal amplified by power amplifier 11 and detection circuit 13 generates a detection voltage.

Control circuit 14 outputs a reference voltage and error amplification circuit 15 amplifies an error by comparing the detection voltage generated by detection circuit 13 and the reference voltage output generated under the instruction of control circuit 14 and generates a control voltage of power amplifier 11.

High frequency variable gain amplifier 16 amplifies the monitor output signal with gain instructed from control circuit 14 between coupler 12 and detection circuit 13. Sample-and-hold circuit 17 passes or holds the detection voltage under the instruction of control circuit 14 between detection circuit 13 and error amplification circuit 15.

Thus, the conventional power amplification apparatus holds a gate voltage value according to a power value as a table beforehand (e.g., control circuit 14) and thereby reduces the gate voltage value when power decreases aiming at amplifying the dynamic range and reducing power consumption in a low power area.

However, the conventional power amplification apparatus has problems of requiring a complicated feedback control circuit such as providing a high frequency variable gain amplifier to extend the dynamic range and amplifying a monitor signal by a control circuit and using a sample-and-hold circuit, etc., which increases the hardware scale.

Moreover, the conventional power amplification apparatus has another problem of requiring a certain control signal to determine the amount of gain of the high frequency variable gain amplifier, which will further increase power consumption.

### Disclosure of Invention

It is an object of the present invention to provide a power amplification apparatus and power amplification method that performs control to reduce power consumption in a low power area intended to reduce the hardware scale.

This object can be attained by providing a gain/offset amplifier, converting a detection voltage to a desired voltage value and then using this voltage as a gate voltage of the power amplifier, and thereby autonomously reducing power consumption in the low power area within the power amplification apparatus without requiring any control signal from outside the power amplification apparatus.

### Brief Description of Drawings

FIG.1 is a main block diagram showing an outlined configuration of a conventional power amplification apparatus;
FIG.2 is a main block diagram showing an outlined configuration of a power amplification apparatus according to Embodiment 1 of the present invention;
FIG.3A is a drawing showing an example of a relationship between an input/output power ratio and detection voltage of the power amplification apparatus according to Embodiment 1 of the present invention;
FIG.3B is a drawing showing another example of a relationship between an input/output power ratio and detection voltage of the power amplification apparatus according to Embodiment 1 of the present invention;
FIG.4 is a main block diagram showing an outlined configuration of a power amplification apparatus according to Embodiment 2 of the present invention;
FIG.5 is a drawing showing an example of a relationship between an input/output power ratio and detection voltage of the power amplification apparatus according to Embodiment 2 of the present invention;
FIG.6 is a main block diagram showing an outlined configuration of a power amplification apparatus according to Embodiment 3 of the present invention;
FIG.7A is a drawing showing an example of a relationship between an input/output power ratio and detection voltage of the power amplification apparatus according to Embodiment 3 of the present invention;
FIG.7B is a drawing showing another example of a relationship between an input/output power ratio and detection voltage of the power amplification apparatus according to Embodiment 3 of the present invention;
FIG.8 is a main block diagram showing an outlined configuration of a power amplification apparatus according to Embodiment 4 of the present invention;
FIG.9 is a drawing showing an example of a relationship between an effective value and maximum amplification value of a detector of the power amplification apparatus according to Embodiment 4 of the present invention;
FIG.10 is a main block diagram showing an outlined configuration of a power amplification apparatus according to Embodiment 5 of the present invention; and
FIG.11 is a drawing showing an example of differences in code multiplexing number in a relationship between an input/output power ratio and detection voltage of the power amplification apparatus according to Embodiment 5 of the present invention.

### Best Mode for Carrying out the Invention

With reference now to the attached drawings, embodiments of the present invention will be explained below.

### (Embodiment 1)

Embodiment 1 of the present invention is a power amplification apparatus provided with a gain/offset amplifier that converts a detection voltage to a desired voltage value and then uses this voltage as a gate voltage of the power amplifier.

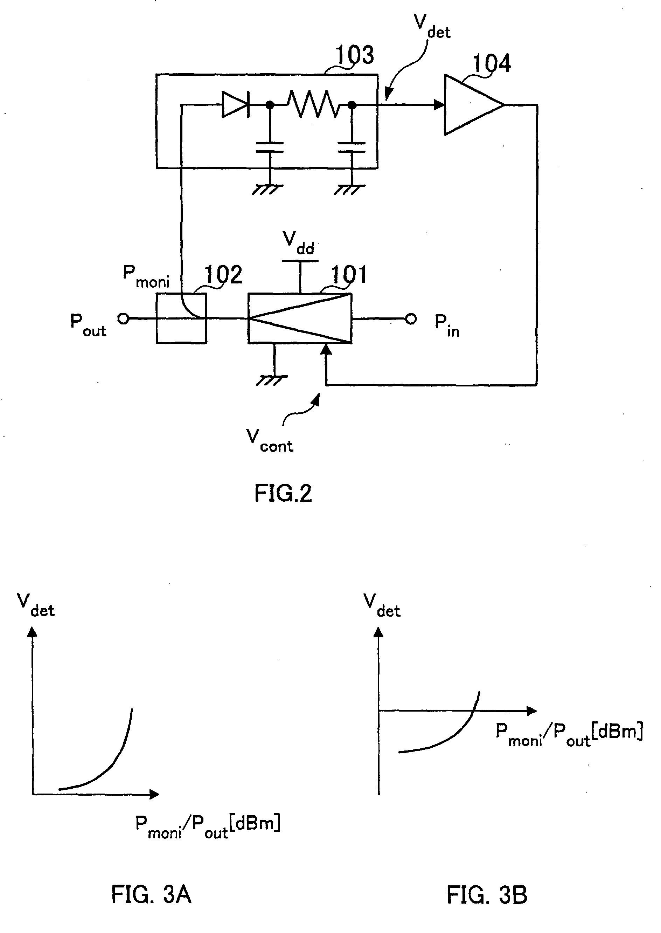

FIG.2 is a main block diagram showing an outlined configuration of the power amplification apparatus according to Embodiment 1 of the present invention.

In FIG.2, power amplifier 101 has at least one current control terminal (e.g., FET gate terminal) and amplifies a high frequency signal. Coupler 102 monitors an amplification signal power Pₘₒₙᵢ of power amplifier 101.

Detector 103 is an envelope detector made up of a diode, capacitor and resistor, etc. and half-wave rectifies input power of a certain level or greater exceeding a forward voltage of the diode (e.g., Pₘₒₙᵢ>-5 dBm) to a linear current, integrates this through an RC filter and generates detection voltage V_{det}.

Gain/offset amplifier 104 performs at least one of amplification of detection voltage V_{det} or application of an offset voltage and converts detection voltage V_{det} to a desired voltage.

Then, the operation of the power amplification apparatus in the above configuration will be explained.

FIG.3A and FIG.3B are drawings showing an example of a relationship between an input/output power ratio and detection voltage of the power amplification apparatus according to Embodiment 1 of the present invention.

The signal amplified by power amplifier 101 is input through coupler 102 to detector 103 where detection voltage V_{det} is generated. The relationship between Pₘₒₙᵢ/Pₒᵤₜ and V_{det} at this time is shown in FIG.3A.

The detection voltage V_{det} generated is converted to a desired voltage by gain/offset amplifier 104 and input to a current control terminal of power amplifier 101. Here, the relationship between Pₘₒₙᵢ/Pₒᵤₜ and V_{det} after conversion is shown in FIG.3B. Here, suppose the amount of gain and offset of gain/offset amplifier 104 are fixed values.

The gate voltage input to the current control terminal of power amplifier 101 varies depending on the characteristic of the power amplifier and is set in an area where no deterioration of a distortion characteristic or no reduction of a gain characteristic, etc. occurs during transmission of power to be output.

Here, when the gate voltage of power amplifier 101 is reduced, the gate-source voltage decreases and the drain current decreases, and therefore gain/offset amplifier 104 performs processing of reducing the detection voltage as shown in FIG.3B and uses the detection voltage as the gate voltage of power amplifier 101 thus reducing current consumption in the low power area.

As described above, this embodiment is provided with a gain/offset amplifier, converts the detection voltage to a desired voltage, then uses this voltage as the gate voltage of the power amplifier, and in this way can autonomously reduce power consumption in a low power area within the power amplification apparatus without requiring any control signal from outside the power amplification apparatus. This embodiment can also drastically reduce the hardware scale of the power amplification apparatus.

### (Embodiment 2)

Here, it is possible to sufficiently carry out detection in a linear area when power has a large amplitude (large power) to produce a sufficient forward voltage. However, when power has a small amplitude (small power), there may be cases where detection is carried out using a non-linear area of a diode, failing to produce a sufficient detection voltage and thus failing to perform envelope detection.

To solve this problem, Embodiment 2 of the present invention applies a bias voltage to the anode terminal of a detection diode in a power amplification apparatus having the same configuration as that of Embodiment 1.

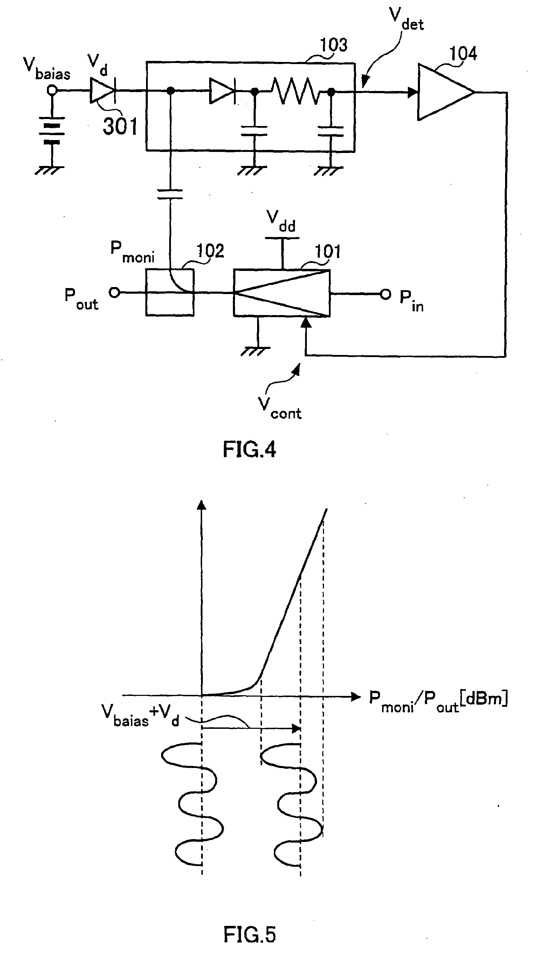

FIG.4 is a main block diagram showing an outlined configuration of the power amplification apparatus according to this embodiment. In FIG.4, the same components as those in FIG.2 are assigned the same reference numerals and detailed explanations thereof will be omitted.

As shown in FIG.4, this embodiment has a new diode 301 connected to the anode terminal of the detection diode in detector 103 and applies bias voltage V_{baias} to the anode terminal of this diode 301.

Here, bias voltage V_{baias} has a fixed value and should be adjusted to an optimal point according to the detection range of transmit power beforehand.

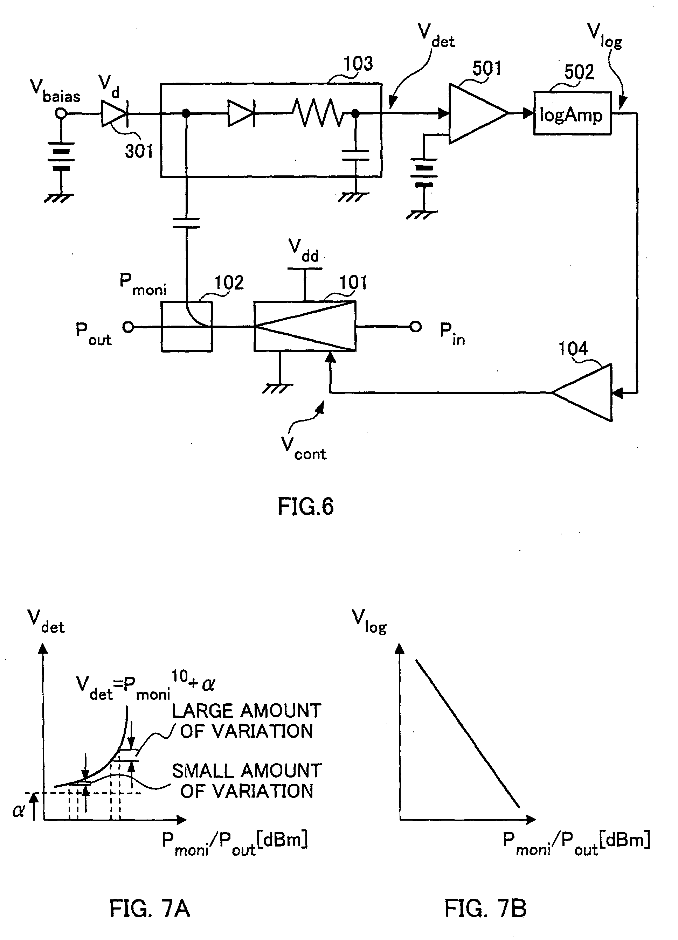

FIG.5 is a drawing showing an example of a relationship between an input/output power ratio and detection voltage of the power amplification apparatus of this embodiment. As shown in FIG.5, the detection operating point elevates when a bias voltage is applied to output power Pₘₒₙᵢ, and therefore it is possible to expand the dynamic range of the transmit power detection voltage, and of the low power area in particular. For example, it is possible detect from approximately Pₘₒₙᵢ=-20 dBm above and control the gate voltage for power in a dynamic range of maximum transmit power ± approximately 30 dB.

As described above, this embodiment raises the detection operating point by applying a bias voltage to the anode terminal of the detection diode and can thereby expand the dynamic range of gate voltage control.

### (Embodiment 3)

Here, input power is generally expressed in absolute values [dBm] using a logarithm. While the diode used for detector 103 has a linear detection characteristic, the detection voltage with respect to input power has a logarithmic characteristic when detection input power is expressed in absolute values [dBm].

Then, when current control is performed for the power amplifier, if the detection voltage continues to have a logarithmic characteristic, the detection voltage characteristic during low power becomes almost constant, making it difficult to perform current reduction control.

To solve this problem, Embodiment 3 of the present invention provides a shift circuit and log amplifier at the output terminal of the detection diode in a power amplification apparatus having the same configuration as that of Embodiment 1, thus converting the detection voltage characteristic to a linear characteristic.

FIG.6 is a main block diagram showing an outlined configuration of the power amplification apparatus according to this embodiment. In FIG.6, the same components as those in FIG.2 are assigned the same reference numerals and detailed explanations thereof will be omitted. FIG.7A and FIG.7B are drawings showing an example of a relationship between an input/output power ratio and detection voltage of the power amplification apparatus of this embodiment.

In FIG.6, shift circuit 501 is configured by an operational amplifier, etc., provided at the output terminal of detector 103 and adds a predetermined voltage to detection voltage V_{det}.

As shown in Embodiment 2, if V_{baias} is set to a high value to raise the operating point of the detection diode, detection voltage V_{det} detected by detector 103 has a characteristic expressed by V_{det}=Pₘₒₙᵢ²+α, and this may prevent full conversion to a linear characteristic by log amplifier 502, which will be described later. Therefore, shift circuit 501 adds a predetermined voltage (here, -α) to detection voltage V_{det} beforehand. This aspect is shown in FIG.7A.

Log amplifier 502 is an inverted type log amplifier and is provided at the output terminal of shift circuit 501 and converts detection voltage V_{det} to V_{log}, which has linearity with respect to Pₘₒₙᵢ/Pₒᵤₜ. This aspect is shown in FIG.7B. Log amplifier 502 is configured by, for example, replacing the load of operational amplifier 101 with a non-linear circuit having a logarithmic characteristic.

Adopting such a configuration makes it possible to convert detection voltage V_{det} having the logarithmic characteristic shown in FIG.7A to detection voltage V_{log} having a linear characteristic.

Thus, this embodiment can convert a detection voltage having a logarithmic characteristic to a detection voltage having a linear characteristic, and thereby can facilitate detection of the amount of variation of the detection voltage in the low power area.

### (Embodiment 4)

Here, in a communication carrying out code multiplexing as in the case of a CDMA system, the effective value of a detection voltage becomes identical, whereas the maximum value of the amplitude varies depending on the code multiplexing number. Thus, when detector 103 performs envelope detection, the detection voltage varies depending on the code multiplexing number even if the same power is used, making it difficult to perform stable current reduction control.

To solve this problem, Embodiment 4 of the present invention performs effective value detection instead of envelope detection in a power amplification apparatus having the same configuration as that of Embodiment 3.

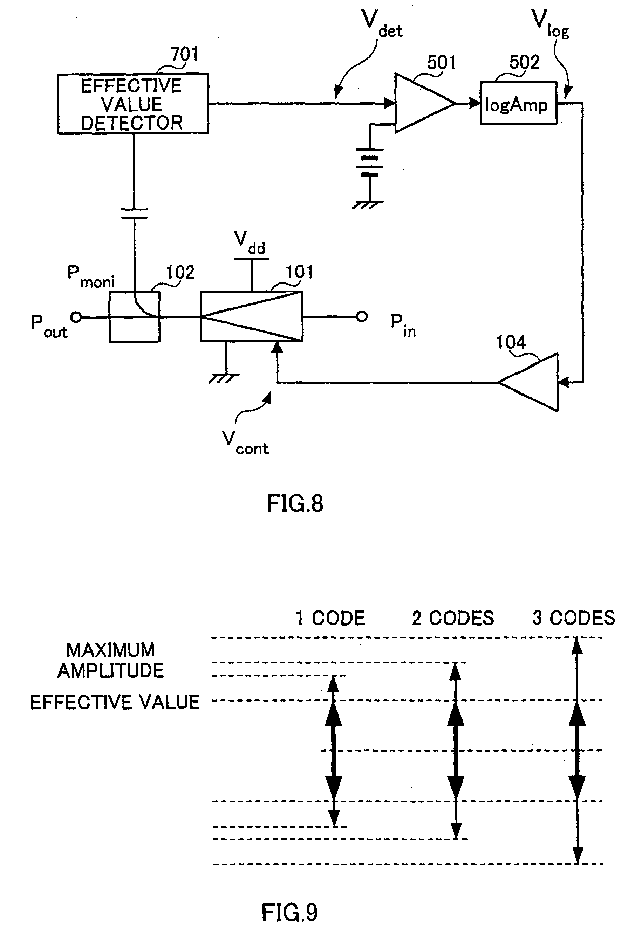

FIG.8 is a main block diagram showing an outlined configuration of the power amplification apparatus according to this embodiment. In FIG.8, the same components as those in FIG.6 are assigned the same reference numerals and detailed explanations thereof will be omitted.

As shown in FIG.8, this embodiment uses effective value detector 701 instead of detector 103 that carries out envelope detection.

FIG.9 is a drawing showing an example of a relationship between an effective value and maximum amplitude in the detector of the power amplification apparatus according to this embodiment.

Thus, this embodiment performs effective value detection instead of envelope detection, and therefore can obtain a stable detection characteristic irrespective of the maximum value of the amplitude even during code multiplexing.

### (Embodiment 5)

Embodiment 5 of the present invention makes the amount of shift voltage variable according to the code multiplexing number in a shift circuit of a power amplification apparatus having the same configuration as that of Embodiment 3.

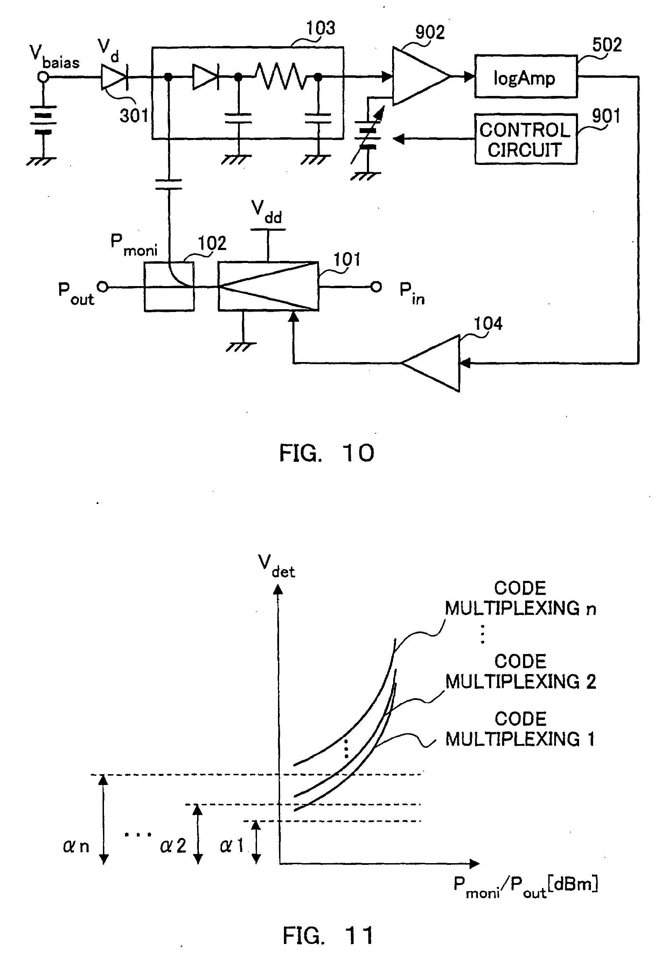

FIG.10 is a main block diagram showing an outlined configuration of the power amplification apparatus according to this embodiment. In FIG.10, the same components as those in FIG.6 are assigned the same reference numerals and detailed explanations thereof will be omitted.

In FIG.10, control circuit 901 generates a code multiplexing control signal indicating the code multiplexing number during code multiplexing and outputs this signal to shift circuit 902. Shift circuit 902 retains an amount of shift voltage α(α1, α2, ··· αn) corresponding to a detection voltage difference during envelope detection with each code multiplexing number n beforehand and controls the amount of shift voltage based on an input code multiplexing control signal.

FIG.11 is a drawing showing an example of differences in the code multiplexing number in the relationship between the input/output power ratio and detection voltage of the power amplification apparatus according to this embodiment.

Thus, this embodiment outputs an identical detection, voltage for identical output power even when the multiplexing number changes and the detection voltage changes by making the amount of shift voltage variable according to the code multiplexing number, making it possible to realize stable current reduction independent of the code multiplexing number.

In the case of Embodiment 1 to Embodiment 5 above, when there is no transmission output, the detection voltage is set in the direction in which no drain current flows, and therefore these embodiments also include a function as a power amplifier protection circuit.

As is apparent from the above explanations, the present invention can autonomously reduce power consumption in a low power area within the power amplification apparatus without requiring any control signal from outside the power amplification apparatus, and therefore can drastically reduce the hardware scale of the power amplification apparatus.

This application is based on the Japanese Patent Application No.HEI 11-203000 filed on July 16, 1999, entire content of which is expressly incorporated by reference herein.

### Industrial Applicability

The present invention is ideally suited to reducing the hardware scale and reducing power consumption of a communication apparatus in a mobile communication system.

## Claims

1. A power amplification apparatus comprising:
power amplifying means having at least one control terminal;
detecting means for detecting the output of this power amplifying means and outputting a detection voltage; and
voltage converting means for converting the detection voltage output from this detecting means to a desired value based on a power value input to said power amplifying means and then outputting this value to said control terminal.

2. The power amplification apparatus according to claim 1, wherein a fixed DC bias voltage is applied to the anode side in the detecting means.

3. The power amplification apparatus according to claim 1, wherein the voltage converting means performs logarithmic conversion by shifting a detection voltage detected by the detecting means.

4. The power amplification apparatus according to claim 1, wherein the detecting means performs effective value detection.

5. The power amplification apparatus according to claim 3, wherein the voltage converting means sets an amount of shift voltage according to a code multiplexing number and performs logarithmic conversion by shifting the detection voltage detected by the detecting means by said amount of shift voltage.

6. A communication terminal apparatus including a power amplification apparatus, said power amplification apparatus comprising:
power amplifying means having at least one control terminal;
detecting means for detecting the output of this power amplifying means and outputting a detection voltage; and
voltage converting means for converting the detection voltage output from this detecting means to a desired value based on a power value input to said power amplifying means and then outputting this value to said control terminal.

7. A base station apparatus including a power amplification apparatus, said power amplification apparatus comprising:
power amplifying means having at least one control terminal;
detecting means for detecting the output of this power amplifying means and outputting a detection voltage; and
voltage converting means for converting the detection voltage output from this detecting means to a desired value based on a power value input to said power amplifying means and then outputting this value to said control terminal.

8. A power amplification method comprising:
a power amplifying step of amplifying an input power value;
a detecting step of detecting the output after power amplification processing and outputting a detection voltage; and
a voltage converting step of converting the detection voltage detected to a desired value based on the input power value in said power amplifying step and then using this value as a control terminal input voltage in said power amplifying step.
